# EUROPEAN PATENT APPLICATION

(11) **EP 1 617 466 A1**
(43) Date of publication of application: **18.01.2006**
(21) Application number: 04747582.7
(22) Date of filing: 15.07.2004
(51) Int. Cl.: H01L 21/304

(54) **METHOD FOR PRODUCING SINGLE CRYSTAL INGOT FROM WHICH SEMICONDUCTOR WAFER IS SLICED**

(30) Priority: 11.08.2003 JP 2003291663
(71) Applicant: Sumitomo Electric Industries, Ltd., Osaka-shi, Osaka 541-0041 (JP)
(72) Inventor: MATSUI, Yasuyuki, Sumiden Sem. Materials Co., Ltd., Itami-shi, Hyogo 6648611 (JP); OTSUKI, Makoto, Sumitomo Electric Industries, Ltd., Itami-shi, Hyogo 6648611 (JP)
(74) Representative: Grünecker, Kinkeldey, Stockmair & Schwanhäusser Anwaltssozietät
(86) International application number: PCT/JP2004/010116
(87) International publication number: WO 2005/015626

(57) **Abstract**

A method of manufacturing single-crystal semiconductor blocks is **characterized in that** a plurality of single-crystal semiconductor blocks (2a) of a relatively small diameter desired by users are cut out from a single-crystal semiconductor block (1a) of a relatively large diameter. With this method, there can also be obtained a secondary effect that even if the large-diameter single-crystal semiconductor block includes defective parts, it is possible to use the small-diameter single-crystal semiconductor blocks cut out from parts other than the defective parts.

## Description

### Technical Field

The present invention relates to a method of manufacturing single-crystal semiconductor blocks, and in particular, to a method of efficiently producing at low costs single-crystal semiconductor blocks for slicing off wafers of a relatively small diameter therefrom.

### Background Art

At present, various types of semiconductor devices are manufactured from single-crystal semiconductor wafers. To improve the production efficiency of the semiconductor devices, there is generally a need to manufacture the semiconductor devices by using single-crystal semiconductor wafers of a diameter as large as possible. Due to such a need, in the case of silicon, a cylindrical single-crystal ingot of a diameter as large as 12 inches (approximately 30 cm) is grown and then sliced by a slicer, a multiwire saw or the like to thereby produce single-crystal silicon wafers of a 12-inch diameter.

In the case of a compound semiconductor such as a III-V group compound or a II-VI group compound, it is much more difficult to grow a large-diameter single-crystal ingot as compared with in the case of silicon. Conventionally, therefore, single-crystal compound semiconductor ingots of a 2-inch diameter have mainly been grown and cut to provide single-crystal compound semiconductor wafers of a 2-inch diameter to be used for manufacturing semiconductor devices.

### Disclosure of the Invention

### Problems to be Solved by the Invention

The technique of growing single-crystal compound semiconductor ingots has been improved in recent years. In some types of compound semiconductors, it is possible to grow a single-crystal ingot having a relatively large diameter of 5 inches (approximately 12.7 cm) or 6 inches (approximately 15.8 cm), for example.

As described above, however, industrially available single-crystal compound semiconductor wafers conventionally have a 2-inch diameter in the main. Therefore, production lines on which single-crystal compound semiconductor wafers are used to manufacture semiconductor devices have conventionally been constructed suitably for the 2-inch wafers. At present, there still exist a large number of such production lines and they are still in operation. Therefore, even if it is possible to grow single-crystal compound semiconductor ingots having a relatively large diameter of 5 inches or 6 inches, for example, the existing production lines still have a demand for single-crystal compound semiconductor wafers having a 2-inch diameter.

Under the circumstances described above, even if a semiconductor wafer provider has a technique of growing single-crystal compound semiconductor ingots having a 5-inch or 6-inch diameter, for example, the provider specially grows single-crystal ingots having a 2-inch diameter to meet the demand for 2-inch diameter wafers. Then, the provider grinds the outer periphery of the ingot, and the grinding includes a process of forming an orientation flat (OF) and, if desired, an index flat (IF) too for indicating a crystal orientation. A notch may be formed instead of the OF and IF. Furthermore, the provider slices the single-crystal semiconductor block and polishes the obtained slices to produce target 2-inch diameter wafers.

As a matter of course, in order to obtain a total wafer area equal to that provided by large-scale wafers of a 5-inch or 6-inch diameter by using small-scale wafers of a 2-inch diameter, several times number of the small-scale wafers are required as compared with the number of the large-scale wafers. To provide such many small-scale wafers, it is necessary to grow many small-diameter ingots.

This means that a large number of single-crystal growth furnaces are required, which is undesirable in terms of costs and efficiency of wafer production. In such a situation, it may be possible to grow a plurality of small-diameter single-crystal ingots in a large furnace in which a large-diameter single-crystal ingot can be grown. In such a large furnace, however, it is difficult to uniformly adjust growth conditions of a plurality of small-diameter single-crystal ingots, and thus it is difficult to obtain at one time a plurality of small-diameter single-crystal ingots having a uniform and preferable crystal quality.

In view of such circumstances of the conventional art, an object of the present invention is to provide a method of efficiently manufacturing at low costs single-crystal semiconductor blocks for slicing off wafers of a relatively small diameter desired by users.

### Means for Solving the Problems

A method of manufacturing single-crystal semiconductor blocks according to the present invention is characterized in that single-crystal semiconductor blocks of a relatively small diameter for slicing off single-crystal semiconductor wafers of a relatively small diameter desired by users are cut out from a single-crystal semiconductor block of a relatively large diameter. Such a method is particularly preferable in the case that the semiconductor is a III-V group compound semiconductor.

The large-diameter single-crystal semiconductor block to be cut preferably has a thickness of at least 10 mm. The small-diameter single-crystal semiconductor blocks can be cut out by any of an electric discharge machining method, a wire saw method, a grinding method by means of a cylindrical core on which diamond is electrically deposited, and a band saw method. In particular, the electric discharge machining method and the wire saw method, which enable easy cutting along both straight and curved lines in a fully-controlled manner, are preferable because these methods can be used to easily form OFs and IFs by setting an XY-driving stage control device.

In the cutting process, at least four small-scale single-crystal semiconductor blocks having a diameter of at least 2 inches can be provided from one large-scale single-crystal semiconductor block having a diameter of at least 5 inches. For efficient use of crystal blocks, a total cross-sectional area of a plurality of small-diameter single-crystal semiconductor blocks cut out from one large-diameter single-crystal semiconductor block preferably corresponds to at least 50% of a cross-sectional area of the large-diameter block. On the other hand, when defective parts included in any cross-sectional area of a large-diameter single-crystal semiconductor block (twin-crystals, polycrystals, crystal slips, chips, cracks or the like) correspond to at most 65% of the cross-sectional area of the large-diameter block, small-diameter single-crystal semiconductor blocks can be cut out from the remaining part of the large-diameter block.

Each of the small-diameter single-crystal semiconductor blocks may be cut out to have any of an orientation flat, an index flat, and a notch for easy determination of its crystal orientation.

### Effects of the Invention

According to the present invention, there can be provided a method of efficiently manufacturing at low costs single-crystal semiconductor blocks of a relatively small diameter desired by users from a single-crystal semiconductor block of a relatively large diameter.

### Brief Description of the Drawings

Fig. 1 is a schematic end face view showing how a single-crystal semiconductor block of a 5-inch diameter is cut to provide four single-crystal semiconductor blocks of a 2-inch diameter in an embodiment according to the present invention.
Fig. 2 is a schematic end face view showing how a single-crystal semiconductor block of a 6-inch diameter is cut to provide five single-crystal semiconductor blocks of a 2-inch diameter in another embodiment according to the present invention.
Fig. 3 is a schematic end face view showing how a single-crystal semiconductor block of a 6-inch diameter is cut to provide seven single-crystal semiconductor blocks of a 2-inch diameter each having an OF and an IF in a further embodiment according to the present invention.
Fig. 4 is a schematic end face view showing how a single-crystal semiconductor block of a 6-inch diameter is cut to provide seven single-crystal semiconductor blocks of a 2-inch diameter in a further embodiment according to the present invention.

### Description of the Reference Signs

1a: single-crystal semiconductor block of a 5-inch diameter; 1b, 1c and 1d: single-crystal semiconductor block of a 6-inch diameter; 2a, 2b and 2c: single-crystal semiconductor block of a 2-inch diameter; 3: single-crystal semiconductor block having a sector-shaped end face; 4: single-crystal semiconductor block of a 2-inch diameter.

### Best Modes for Carrying Out the Invention

### (First Embodiment)

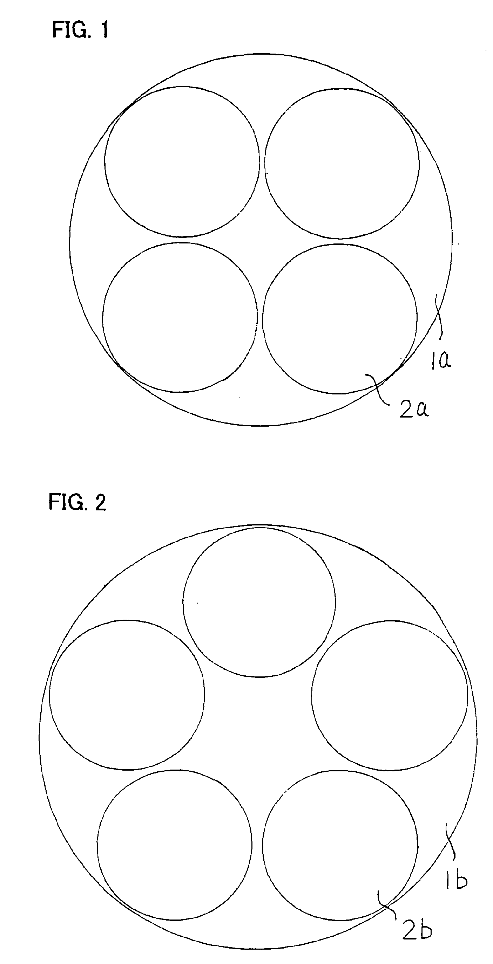

Fig. 1 is a schematic end face view illustrating a process of manufacturing single-crystal semiconductor blocks of a relatively small diameter from a single-crystal semiconductor block of a relatively large diameter in a first embodiment according to the present invention. At present, for a GaAs compound semiconductor for example, it is possible to grow a single-crystal ingot having a relatively large diameter of 5 inches or 6 inches. For an InP compound semiconductor also, it is almost possible to grow a single-crystal ingot having a relatively large diameter.

In the first embodiment, there is initially grown a single-crystal compound semiconductor ingot of a 5-inch diameter (actually, the diameter is slightly larger than 5 inches for including a grinding allowance), and then its outer periphery is ground and an OF is formed thereon. As shown in Fig. 1, a single-crystal semiconductor block of a 5-inch diameter la whose outer periphery has been ground can then be cut by wire electric discharge machining for example, to provide four single-crystal semiconductor blocks 2a of a 2-inch diameter.

In the wire electric discharge machining, a large-diameter single-crystal semiconductor block is mounted on an XY-driving stage. While the XY-driving stage is being driven, a wire is moved in its lengthwise direction parallel to the axial direction of the single-crystal block and allowed to discharge electricity, so that small-diameter single-crystal semiconductor blocks can be cut out along its cylindrical surface. The axial length of the large-diameter single-crystal semiconductor block to be cut is not particularly limited, and it is possible to cut the large-diameter block even in the case that it has a length (or thickness) of more than 10 mm. The wire electric discharge machining requires cutting allowance of approximately at most several hundreds µm, which can reduce the unusable part caused by the cutting allowance in the single crystal.

According to the embodiment as described above, a single process of growing a 5-inch diameter ingot and a single process of cutting out single-crystal blocks can provide four times as many 2-inch diameter single-crystal semiconductor blocks as in the case of growing a 2-inch diameter ingot.

Each of the cut-out single-crystal semiconductor blocks of 2-inch diameter has its periphery ground and is provided with an OF, an IF, or a notch. Thereafter, the blocks are sliced to provide 2-inch diameter wafers.

### (Second Embodiment)

Fig. 2 is a schematic end face view illustrating a process of manufacturing single-crystal semiconductor blocks of a 2-inch diameter from a single-crystal semiconductor block of a 6-inch diameter in a second embodiment according to the present invention. This process of manufacturing can be carried out similarly as in the first embodiment described above.

Namely, in the second embodiment, there is initially grown a single-crystal compound semiconductor ingot of a 6-inch diameter (actually, the diameter is slightly larger than 6 inches for including a grinding allowance), and then its outer periphery is ground and an OF is formed thereon. As shown in Fig. 2, a single-crystal semiconductor block 1b of a 6-inch diameter whose outer periphery has been ground can then be cut by wire electric discharge machining similarly as in the first embodiment to provide five single-crystal semiconductor blocks 2b of a 2-inch diameter.

In other words, a single process of growing a 6-inch diameter ingot and a single process of cutting out crystal blocks can provide five times as many 2-inch diameter single-crystal semiconductor blocks as in the case of growing a 2-inch diameter ingot.

### (Third Embodiment)

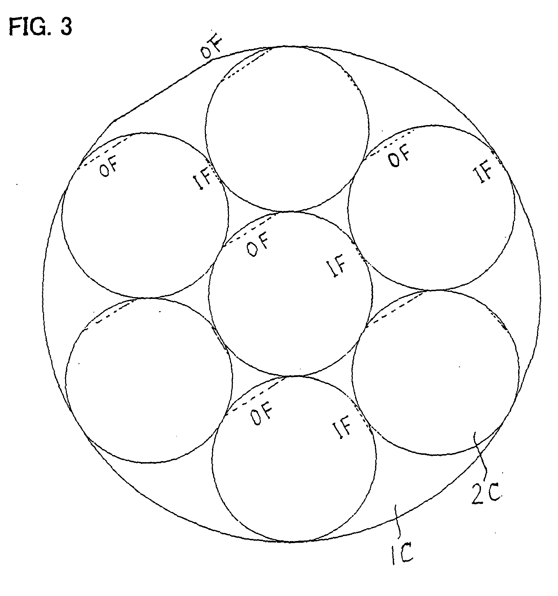

Fig. 3 is a schematic end view concerning a third embodiment similar to the second embodiment of the present invention, illustrating a process of manufacturing single-crystal semiconductor blocks of a 2-inch diameter from a single-crystal semiconductor block of a 6-inch diameter. This process of manufacturing can also be carried out similarly as in the first and second embodiments described above.

Namely, in the third embodiment, there is initially grown a single-crystal compound semiconductor ingot of a 6-inch diameter (actually, the diameter is slightly larger than 6 inches for including a grinding allowance), and then its outer periphery is ground and an OF is formed thereon. As shown in Fig. 3, a single-crystal semiconductor block of a 6-inch diameter 1 c whose outer periphery has been ground can then be cut by wire electric discharge machining similarly as in the first and second embodiments to provide seven single-crystal semiconductor blocks 2c of a 2-inch diameter.

In other words, in the third embodiment, a single process of growing a 6-inch diameter ingot and a single process of slicing the ingot can provide seven times as many 2-inch diameter single-crystal semiconductor blocks as in the case of growing a 2-inch diameter ingot, similarly as in the second embodiment.

In the third embodiment in Fig. 3, each of single-crystal semiconductor blocks of a 2-inch diameter is cut out having an OF and an IF. Such an OF and an IF of each of small-diameter single-crystal semiconductor blocks 2c can be formed during cutting out those small-diameter blocks by wire electric discharge machining, with reference to an OF of large-diameter single-crystal semiconductor block 1c, for example.

### (Fourth Embodiment)

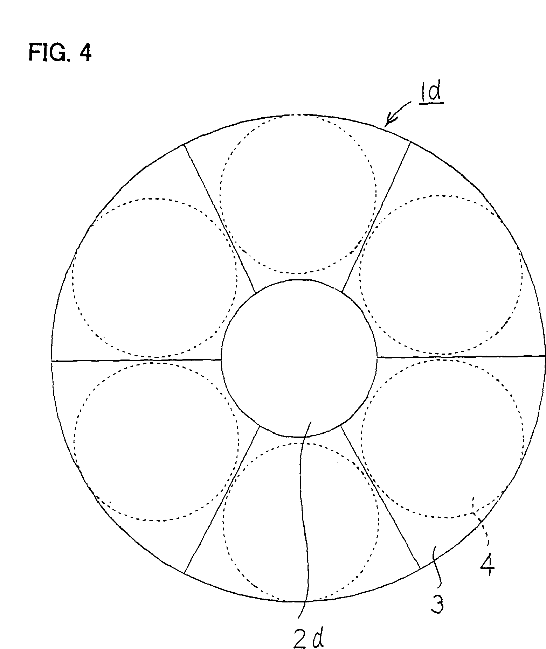

Fig. 4 is a schematic end face view concerning a fourth embodiment similar to the third embodiment according to the present invention, illustrating a process of manufacturing single-crystal semiconductor blocks of a 2-inch diameter from a single-crystal semiconductor block of a 6-inch diameter. In the fourth embodiment, a small-diameter single-crystal semiconductor block 2d is cut out including the central part of an end face of a large-scale single-crystal semiconductor block 1d, by wire electric discharge machining similarly as in the third embodiment.

Thereafter, the remaining thick-walled cylindrical single-crystal block is cut by a band saw to provide six single-crystal blocks 3 each having a sector-shaped end face. The band saw can achieve a much higher cutting rate as compared with the wire electric discharge machining.

Then, single-crystal blocks 3 each having a sector-shaped end face have their peripheries ground to be made into small-diameter single-crystal cylindrical semiconductor blocks 4 of a 2-inch diameter. Accordingly, seven small-diameter single-crystal semiconductor blocks in total can efficiently be obtained from one large-diameter single-crystal semiconductor block.

Although several embodiments according to the present invention have been described in the above, it is more difficult to grow a large-diameter single-crystal ingot than to grow a small-scale single-crystal ingot, because various defects including twin crystals, polycrystals, crystal slips and others are more likely to be caused during growing a large-diameter single-crystal ingot than a small-diameter single-crystal one. Conventionally, a large-scale wafer cut out from a part including such a defect cannot be shipped as a product and goes to waste. However, with a method of manufacturing small-diameter single-crystal semiconductor blocks according to the present invention described above, there can be obtained a significant advantage that a large-diameter single-crystal semiconductor block including a defect(s) can be cut into small-diameter single-crystal semiconductor blocks, among which those having been cut out from nondefective parts can be shipped as products.

In the aforementioned embodiments, although a wire electric discharge machining method and a band saw method are described as a method of cutting out small-diameter single-crystal semiconductor blocks from a large-diameter single-crystal semiconductor block, it is also possible to use for electric discharge machining a thin-walled cylindrical discharging electrode having a peripheral shape corresponding to the shape of a small-diameter single-crystal semiconductor block to be cut out. In addition to these cutting methods, it is further possible to use a wire saw method and a grinding method by means of a cylindrical core on which diamond is electrically deposited. Furthermore, of course, the various cutting method described above may be conveniently combined.

Although a large-scale single-crystal compound semiconductor block to be cut out has a 6-inch diameter at most at present, it goes without saying that the present invention can be applied to a single-crystal semiconductor block having a larger diameter of 8 inches or 12 inches which will be manufactured in the future. Similarly, although small-scale single-crystal semiconductor blocks to be cut out have a 2-inch diameter in the aforementioned embodiments, it goes without saying that the present invention can be used even in the case that a large-diameter single-crystal semiconductor block to be manufactured in the future is cut into small-scale single-crystal semiconductor blocks having a diameter of 3 inches or more (for example, a 9-inch diameter single-crystal semiconductor block can be cut to provide seven 3-inch diameter single-crystal semiconductor blocks). Moreover, in the present invention, small-scale single-crystal semiconductor blocks to be cut out from a large-scale single-crystal semiconductor block are not required to have the same diameter. For example, it is also possible to cut one large-scale single-crystal semiconductor block to provide a small-scale single-crystal semiconductor block(s) of a 2-inch diameter and one(s) of a 3-inch diameter simultaneously.

Incidentally, the electrical properties of small-diameter single-crystal semiconductor blocks cut out from a large-diameter single-crystal semiconductor block are not concentrically symmetric except for those cut out from the central part of the large-diameter single-crystal semiconductor block.

### Industrial Applicability

As described above, according to the present invention, it is possible to efficiently provide at low costs single-crystal semiconductor blocks of a relatively small diameter desired by users, by cutting out the same from a single-crystal semiconductor block of a relatively large diameter.

## Claims

1. A method of manufacturing single-crystal semiconductor blocks, wherein single-crystal semiconductor blocks (2a) of a relatively small diameter for slicing off single-crystal semiconductor wafers of a relatively small diameter desired by users are cut out from a single-crystal semiconductor block (1a) of a relatively large diameter.

2. The method of manufacturing single-crystal semiconductor blocks according to claim 1, wherein said semiconductor is a III-V group compound semiconductor.

3. The method of manufacturing single-crystal semiconductor blocks according to claim 1, wherein said large-diameter single-crystal semiconductor block has a thickness of at least 10 mm.

4. The method of manufacturing single-crystal semiconductor blocks according to claim 1, wherein said small-diameter single-crystal semiconductor blocks are cut out by any of an electric discharge machining method, a wire saw method, a grinding method by means of a cylindrical core, and a band saw method.

5. The method of manufacturing single-crystal semiconductor blocks according to claim 1, wherein at least four said small-scale single-crystal semiconductor blocks having a diameter of at least 2 inches are cut out from said large-scale single-crystal semiconductor block having a diameter of at least 5 inches.

6. The method of manufacturing single-crystal semiconductor blocks according to claim 1, wherein a total cross-sectional area of a plurality of said small-diameter single-crystal semiconductor blocks cut out from said large-scale single-crystal semiconductor block corresponds to at least 50% of a cross-sectional area of said large-scale single-crystal semiconductor block.

7. The method of manufacturing single-crystal semiconductor blocks according to claim 1, wherein defective parts included in any cross-sectional area of said large-diameter single-crystal semiconductor block correspond to at most 65% of said cross-sectional area.

8. The method of manufacturing single-crystal semiconductor blocks according to claim 1, wherein each of said small-diameter single-crystal semiconductor blocks is formed to have at least any of an orientation flat, an index flat, and a notch for easy determination of its crystal orientation.
